(19) Europäisches Patentamt
European Patent Office
Office européen des brevets

(11) **EP 1 209 729 A1**

(12) **EUROPEAN PATENT APPLICATION**
published in accordance with Art. 158(3) EPC

(43) Date of publication:
**29.05.2002 Bulletin 2002/22**

(51) Int Cl.7: **H01L 21/318**, H01L 29/78,
H01L 29/788, H01L 29/792,
H01L 21/8247, H01L 27/10

(21) Application number: **00944272.4**

(22) Date of filing: **06.07.2000**

(86) International application number:
**PCT/JP00/04477**

(87) International publication number:
**WO 01/04943 (18.01.2001 Gazette 2001/03)**

(84) Designated Contracting States:
**AT BE CH CY DE DK ES FI FR GB GR IE IT LI LU
MC NL PT SE**

(30) Priority: **07.07.1999 JP 19265999**

(71) Applicant: **MATSUSHITA ELECTRIC INDUSTRIAL
CO., LTD.**
**Kadoma-shi, Osaka 571-8501 (JP)**

(72) Inventor: **NISHIKAWA, Takashi**
**Osaka 565-0875 (JP)**

(74) Representative: **Grünecker, Kinkeldey,
Stockmair & Schwanhäusser Anwaltssozietät
Maximilianstrasse 58
80538 München (DE)**

(54) **MULTILAYERED BODY, METHOD FOR FABRICATING MULTILAYERED BODY, AND
SEMICONDUCTOR DEVICE**

(57) A Si substrate (1) is cleansed by acid treatment, for example, and heated to remove attachments on its surface. Then, nitrogen is turned into a plasma and supplied to the surface of the Si substrate (1), and due to the surfactant effect of radical nitrogen, an AIM crystal layer (80) is formed on the surface of the Si substrate (1), not matching the lattice of the Si crystal. The lattice distance of the AIN crystal layer (80) substantially matches the usual lattice constant of AIN crystals, so there is no strain in the Al crystal layer (80) caused by a difference in lattice constant with the Si substrate (1), as would be the case when the lattice matches with the Si substrate (1).

Fig. 11(a)  2 dangling bonds  1 Si substrate

Fig. 11(b)  3  4  Al  N  5b  1

Fig. 11(c)  80 AIN crystal layer  1

EP 1 209 729 A1

**Description**

TECHNICAL FIELD

The present invention relates to a layered structure made by layering a group-III element nitride film on a crystalline layer, a manufacturing method for the same, and a semiconductor element using the same.

BACKGROUND ART

In recent years, considerable progress has been made in CMOS devices formed on Si substrates with regard to the miniaturization of the elements configuring these devices, such as MOS transistors, and the high integration of these elements. Along with these advancements in miniaturization and high integration, a strong demand has developed for an improvement in the capacitance per unit area of the gate insulating film, which is an element of a MOS transistor, for example, so as to reduce the power source voltage for operating the elements of a MOS device in order to conserve power. However, to ensure the charge that is necessary to perform the same element operation as conventionally, the capacitance per unit area of the gate insulating film must be raised.

Broadly speaking, there are two methods for increasing the capacitance of the gate insulating film. The first method is to make the gate insulating film thin, and the second method is to make the gate insulating film of a material with a higher dielectric constant. That is to say, there are two approaches to improving the performance of the gate insulting film: making it thin and increasing the dielectric constant.

To make the gate insulating film thin, there are a particularly large number of techniques attempting to achieve thermal oxidation of a Si substrate with high precision. The method of fabricating a silicon dioxide ($SiO_2$) insulating film by thermal oxidation of the Si substrate is advantageous in that with this method, for example, the formation of an oxide film is easy, the oxide film has extremely good properties as a gate insulating film, including a low interface state density, high breakthrough voltage properties, and small current leakage, and moreover the fabrication process of the oxide film can sufficiently keep up with the miniaturization and high integration of elements. Therefore, with regard to the current CMOS transistors that are formed on Si substrates, it would not be an overstatement to say that apart from thermal oxidation, there are no other methods in practical use for the manufacture of gate insulating films. Consequently, most studies on increasing the performance of increasing gate insulating film properties address how to make the $SiO_2$ films thinner. For example, as disclosed in "The National Technology Roadmap for Semiconductors (The Semiconductor Industry in the U.S.A) page 74, table 22" (first document), which assesses future perspectives for Si transistor research, it is predicted that the thickness of gate insulating films, which in the year 1997 was 4 to 5 nm, will become 2 to 3 nm by the year 2001. Moreover, as a study of how to meet the demands for thinner $SiO_2$ films, the "Technical Report of IEICE, ED98-9, SDM98-9 (1998-04) page 15" (second document) discloses a method for thermal oxidation using a fast oxidation process with rapid-heating and rapid-quenching. According to the method in this document, the film thickness of the fabricated $SiO_2$ film is 1.5 nm.

An example of a method for increasing the dielectric constant of the material that forms the gate insulating film is disclosed in "Applied Physics Letters 72, 2835, (1998)" (third document). This method uses a layered film of $SiO_2/Ta_2O_5/SiO_2$ (three-layer film) as the gate insulating film instead of using a $SiO_2$ single layer film. This layered state utilizes the large dielectric constant of the $Ta_2O_5$ of 20 to 25 to raise the amount of stored charge per unit area, and extremely thin $SiO_2$ layers, which are formed by direct thermal oxidation of the Si, are interposed between the $Ta_2O_5$ and the Si substrate to avoid introducing a high density of interface states to the interface between the Si substrate and the insulating film made of a high dielectric material when the insulating film is in contact with the Si substrate.

Stemming from a requirement separate from those mentioned above, attempts have been made to make gate insulating films with materials other than $SiO_2$. For example, in the method disclosed in JP H01-64789A (fourth document), the gate insulating film is made using Yttrium Stabilized Cubic Zirconia (hereinafter, abbreviated as YSZ) instead of $SiO_2$, so as to increase the breakthrough properties of the gate insulating film when it is irradiated with high energy radiation by X-ray exposure, for example. In contrast to the normally amorphous $SiO_2$ and $Ta_2O_5$, the YSZ used here has crystallinity.

From further separate requirements, there have been attempts to make the gate insulating film with a material other than $SiO_2$. For example, in the method disclosed in "Japan Journal of Applied Physics 35, 4987 (1996)" (fifth document), studies were conducted for attaining a transistor with memory effect using a thin film with ferroelectric properties as the gate insulating film of a field effect transistor. Here a $PbZr_{1-x}Ti_xO_3$ (PZT) thin film, which has particularly good ferroelectric properties, was used as the gate insulating film. However, this PZT film is hard to form directly onto a Si substrate, so an insulating film made of a different material like $CeO_2$ was interposed between the PZT film and the Si substrate.

PROBLEMS TO BE SOLVED

However, there are several problems with making $SiO_2$ films thin and developing new gate insulating film materials as in the above-mentioned documents, as will be shown in the following.

The first document predicts that by the year 2006 a gate film thickness of 1.5 to 2 nm will be achieved, but it is not thought to be possible to achieve a $SIO_2$ film at a thickness any thinner than 1.5 nm beyond that point, and moreover that it seems that no further solutions are conceivable. That is, it is believed that reducing the thickness of a $SiO_2$ film to 1.5 nm or less and using that film as the gate insulating film of a device is unachievable. It would appear that the reason for this is that a direct tunneling current flows through the film in $SiO_2$ films thinner than 1.5 nm. This occurrence of a direct tunneling current is a particularly serious problem in the memory cell transistors of DRAMs. Thus, there is a need for a new gate insulating film material with a higher dielectric constant and properties (like a low density of interface states) on par with $SiO_2$ films, so as to secure a desired charge using a film of a thickness at which direct tunneling current does not occur.

The second document reported that an extremely thin $SiO_2$ film of 1.5 nm has been fabricated with good properties, such as breakdown voltage, leakage properties, and high frequency properties. On the other hand, it has very serious deficiencies with regard to reliability. That is, there is a notable occurrence of impurity (boron, for example) penetration from the gate electrode when a very thin $SiO_2$ film is used as a gate insulating film. For example, the second document reports how when a gate electrode made of polycrystalline silicon was provided on the gate insulating film in a PMOSFET, the boron (B) used as the dopant passed from the gate electrode through the $SiO_2$ film and penetrated into the Si substrate.

The third document reports that with a three-layered film structure introduced to attain increased breakthrough voltage, the equivalent thickness of the $SiO_2$ can be given at 2.3 nm. However, the interface state density was three times that of a $SiO_2$ film with a film thickness of 2.3 nm.

In the fourth document, a gate insulating film made of YSZ was fabricated, however, as YSZ tends to pass molecules and ions easily enough that it is used in oxygen sensors for automobile engines, current leakage easily occurs between the gate electrode and the channel due to the contribution of ionic conduction, for example. This means that it is difficult to obtain a gate insulting film having a high breakthrough voltage and reliability.

In the fifth document, a buffer layer made of a $CeO_2$ film must be fabricated before forming the PZT film, which is a ferroelectric film. Ferroelectric materials other than PZT often include heavy metals such as Bi, Pb, Ta, Sr, or Ba, so there is a large risk that these metals will diffuse into the Si substrate and negatively affect the electrical characteristics of the channel. The results of the secondary ion mass spectrometry (SIMS) measurement in this document indicate that Pb had diffused into the Si substrate. Additionally, as these ferroelectric materials are oxides of composite materials, there is a large risk that a $SiO_2$ region will be formed at the interface between the ferroelectric film and the Si substrate. When a $SiO_2$ region is formed at this interface, there is the problem that a large part of the voltage applied to the gate electrode in the MOS transistor structure often gets applied to this low dielectric constant $SiO_2$ region, thereby lowering the effective voltage applied to the ferroelectric film itself. Thus, there is the problem that switching is not carried out efficiently.

Thus, an object of the present invention is to provide a method for manufacturing a film which can sufficiently keep up with progress in the miniaturization and high integration of elements, and a semiconductor element which uses the same, wherein the film is manufactured using a material for the gate insulating film material different from the gate insulating film materials that have already been disclosed above, and with which superior properties can be attained.

DISCLOSURE OF THE INVENTION

A layered structure according to the present invention includes a substrate having a crystal layer, and a crystalline compound film, which is epitaxially grown on a principal face of the crystal layer, whose orientation follows the orientation of the crystal layer, which has a crystal lattice that does not match a lattice of the crystal layer, and which has a larger bonding strength between atoms than the crystal layer.

Thus, the positioning of the crystal lattice of the crystalline compound film and the crystal layer of the primer do not have to match precisely, so there is no strain in the crystalline compound film caused by lattice matching with the crystal layer of the primer. Consequently, it is possible to obtain a crystalline compound film, such as a nitride film, with only few interface states caused by strain, for example. Therefore, the layered structure can be applied to a variety of devices, such as MIS transistors with good properties in which a nitride film, for example, is used as the gate insulating film, MFIS transistors in which a crystalline ferroelectric film is further provided on the nitride film, or capacitors in which the nitride film serves as the capacity insulating film.

When the crystalline compound film is a group-III element nitride film, the group-III element nitride film crystallizes particularly easily and has a large bonding strength between atoms. Thus, a crystal film with lattice mismatch is easily obtained.

When the crystal layer is a Si crystal layer and the principal face of the Si crystal layer is the (111) plane, it becomes particularly easy to provide the crystalline compound film, such as a nitride film, in a state of lattice mismatch on the crystal layer.

In this case, when the crystalline compound film is an AlN film, a state of lattice mismatching can be attained reliably while the crystalline compound film retains the orientation information of the crystal layer of the primer.

A first method for manufacturing a layered structure according to the present invention includes alternately repeating a step (a), wherein a first atom layer of either a group-III element atom layer or a N atom layer is formed on a principal face of a crystal layer of a substrate, and a step (b), wherein a second atom layer of the other of the group-III element atom layer or the N atom layer is formed on the first atom layer, thereby epitaxially growing a crystalline group-III element nitride film on the crystal layer.

With this method, a crystalline nitride film can be formed inheriting the information of the crystal layer of the primer and having good properties, such as a high dielectric constant, due to its high crystallinity, and on this crystalline nitride film another crystalline film can be formed. Thus, this method can be incorporated into the processing of a variety of devices with excellent properties.

If in step (a), a N atom layer is formed, and in step (b) a group-III element atom layer is formed, thus epitaxially growing a crystalline group-III element nitride film on the crystal layer, wherein the crystalline group-III element nitride film has a crystal lattice that does not match the position of the crystal lattice of the principal face of the substrate, the surfactant effect when N atoms stick to the principal face of the crystal layer can be utilized to form a crystalline nitride layer with a lattice that does not match the lattice of the crystal layer of the primer yet which inherits information about the orientation of the crystal layer of the primer.

When the crystal layer is a Si crystal layer and the principal face of the Si crystal layer is the (111) plane, the greatest surfactant effect can be obtained.

By forming an Al atom layer in step (b), an AlN film is formed as the nitride film, and utilizing the fact that the AlN film is easily formed into a crystal and has a high dielectric constant, the above-described operational effect can be noticeably achieved.

If the deposition of the N atom layer is performed by a molecular beam epitaxy (MBE) method, in which radical nitrogen made by turning nitrogen gas into a plasma is supplied to the principal face of the crystal layer, then a high surfactant effect can be attained when the activated radical nitrogen adheres to the principal face of the crystal layer of the primer.

By turning the nitrogen gas into a plasma using a plasma cell, it is possible to easily and accurately control the supply of the plasma of radical nitrogen.

A second method for manufacturing a layered structure according to the present invention includes a step (a), wherein a principal face of a Si crystal layer of a substrate is exposed to an atmosphere including one of nitrogen, hydrogen, sulfur and magnesium, to terminate dangling bonds on the primary surface of the semiconductor substrate, and a step (b), wherein a crystalline AlN layer is formed on the Si crystal layer.

With this method, an AlN film with a small interface state density and excellent non-deterioration properties, for example, can be obtained because the AlN layer is formed in a state wherein the dangling bonds on the surface of the Si crystal layer as the primer have been terminated.

If a step is further included before step (b), wherein the surface of the Si crystal layer is nitrogenized to form a silicon nitride layer, and in step (b) a crystalline AlN layer is formed on the silicon nitride layer, then the dangling bonds at the surface of the Si crystal layer can be terminated even more reliably.

It is preferable that in step (b) at least one of oxygen, hydrogen and sulfur is added to the AlN film to relieve strain in the AlN layer resulting from lattice mismatch with the Si crystal layer.

A semiconductor element according to the present invention includes a substrate having a semiconductor layer, an insulating film provided on the semiconductor layer and having an AlN layer, and an electrode provided on the gate insulating film and made from a conductor.

Thus, there is an increase in the capacitance per unit area of the overall insulating film having an AlN layer with a higher dielectric constant than a silicon oxide film fabricated by thermal oxidation. In the compact crystalline AlN layer there are hardly any defects or interface states, so good reliability on par with silicon oxide films can be achieved. Also, this insulating film can be used as the gate insulating film of a field effect transistor or the capacity insulating film of a MIS capacitor.

It is preferable that the AlN layer is a monocrystalline layer epitaxially grown on the semiconductor layer.

When the semiconductor layer is a Si crystal layer and the position of the principal face of the semiconductor layer is the (111) plane, then the AlN layer is a dense hexagonal crystal whose principal face is the (0001) plane.

When the semiconductor layer is a Si crystal layer and the principal face of the semiconductor layer is the (100) plane, then the AlN layer is a cubic crystal whose principal face is the (100) plane.

By terminating the dangling bonds at the surface of the semiconductor layer by one of aluminum, nitrogen, hydrogen, sulfur and magnesium, the density of the interface states at the interface between the AlN layer and the semiconductor layer can be reduced.

By making the insulating film a gate insulating film and further providing a silicon nitride layer between the AlN layer and the semiconductor layer, it is possible to maintain the crystallinity of the Si substrate primer as it is, while due to the presence of the silicon nitride layer, further reducing the dangling bonds at the surface of the semiconductor substrate, and significantly reducing the density of the interface states at the interface with the semiconductor substrate. Also, with the silicon nitride layer it is also possible prevent impurities from passing through the AlN layer and diffusing toward the side of the semiconductor substrate.

A semiconductor element can be obtained which functions as a MFISFET, for example, when the semiconductor element is given the structure of a field effect transistor by making the insulating film a gate insulating film, and further providing a dielectric layer on the AlN layer, wherein the dielectric layer is configured by at least one of a dielectric material with a higher dielectric constant than AlN, and a material having ferroelectric properties. In this case, by providing a dielectric layer on the highly crystalline AlN layer, a highly crystalline tetragonal dielectric layer can be attained. Consequently, it is possible to attain a high dielectric film with a higher dielectric constant or a ferroelectric film with even better remanent polarity holding properties.

A semiconductor element can be obtained which functions as a MFMISFET, for example, when in the semiconductor element the insulating film is a gate insulating film, a dielectric layer is further provided on the AlN film, wherein the dielectric layer is configured by at least one of a dielectric material with a higher dielectric constant than the formed AlN, and a material having ferroelectric properties, and a crystalline conductive element is provided either above or below, or above and below, the dielectric layer.

In the semiconductor element, by including at least one of oxygen, hydrogen and sulfur in the AlN layer to relieve strain in the AlN layer resulting from lattice mismatching with the semiconductor substrate, a highly reliable semiconductor element with a gate insulating film that only slightly deteriorates over time can be achieved.

In the semiconductor element, it is also possible to expand lattice mismatching between the AlN layer and the semiconductor substrate so as to increase the dielectric constant of the AlN layer

BRIEF DESCRIPTION OF THE DRAWINGS

Figs. **1(a)** to **1(d)** are cross sectional views illustrating the procedure for forming an AlN crystal layer according to the first embodiment.

Figs. **2(a)** to **2(g)** are cross sectional views illustrating the procedure for forming an AlN crystal layer according to the second embodiment.

Figs. **3(a)** to **(c)** are cross sectional views illustrating the procedure for forming an AlN crystal layer, a dielectric thin film, and a gate polysilicon film for use in a MFISFET, for example, according to the third embodiment.

Figs. **4(a)** to **4(e)** are cross sectional views illustrating the steps for forming an AlN crystal layer, a crystalline dielectric thin film, and first and second conductive thin films, for use in a MFMISFET, for example, according to the fourth embodiment.

Figs. **5(a)** to **5(c)** are cross sectional views illustrating the process steps for forming a silicon nitride layer, an AlN thin film, and a polysilicon film, for use in a MISFET, for example, according to the fifth embodiment.

ment.

Fig. **6** is a cross sectional view showing the structure of the MISFET according to the seventh embodiment.

Fig. **7** is a band diagram showing the energy bands of a Si crystal, a $SiO_2$ dielectric, and an AlN crystal.

Fig. **8** is a cross sectional view schematically showing the configuration of a MBE device used in the eighth embodiment.

Fig. **9** is a cross sectional view showing the configuration of the plasma cell.

Fig. **10** is a diagram illustrating the timing of the opening and closing of the shutters for the plasma cell and the K-cell when epitaxially growing the AlN crystal layer according to the eighth embodiment.

Figs. **11(a)** to **11(c)** illustrate the process for epitaxially growing the AlN crystal layer according to the eighth embodiment.

Fig. **12** shows a TEM image of a vertical cross section of the layered structure with the Si substrate and the AlN crystal layer according to the eighth embodiment.

Fig. **13** shows an electron beam diffraction image of the AlN crystal layer epitaxially grown in the eighth embodiment.

BEST MODE FOR CARRYING OUT THE INVENTION

*Regarding the Basic Characteristics of AlN*

Before the embodiments of the present invention are described, first a description will be given regarding the basic characteristics of the AlN film used in the present invention as a new material for gate insulating films, for example.

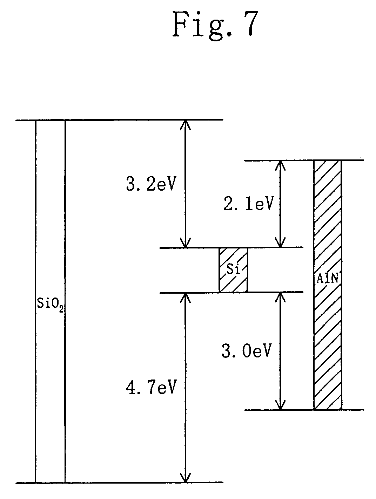

Fig. **7** is a band diagram for comparing the band discontinuities of the energy bands of AlN and $SiO_2$ with respect to Si.

As shown in Fig. **7**, the band gap of $SiO_2$ (difference in energy level between conduction band and valance band; in other words, the width of the forbidden zone) is approximately 9 eV. There is a band discontinuity of approximately -4.7 eV between the valance band edge of $SiO_2$ and the valance band edge of Si. Moreover, there is a band discontinuity of approximately 3.2 eV between the conduction band edge of $SiO_2$ and the conduction band edge of Si. On the other hand, the band gap of AlN is approximately 6.4 eV. There is a band discontinuity of approximately -3.0 eV between the valance band edge of AlN and the valance band edge of Si. Moreover, there is a band discontinuity of approximately 2.1 eV between the conduction band edge of AlN and the conduction band edge of Si. This means that the band discontinuity between AlN and Si is 64% (valance band side) and 66% (conduction band side) of the band discontinuity between $SiO_2$ and Si.

Moreover, as there is only a very small number impurities or defects generating carriers in the AlN film, high insulation properties can be maintained. Also, AlN has few Si dangling bonds at the interface with Si, so there is an extremely low interface state density at the interface with Si.

These facts show that AlN films can be adequately used as gate insulating films or other barrier films by interposing the AlN film between the Si and the conductor in opposition to the Si.

Silicon crystals have a diamond structure, and AlN crystals have a wurtzite type crystal structure resembling the crystal structure of zinc blende. Zinc blende crystal structures are a type of cubic, in which one type of atoms in a diamond type structure alternate with a different type of atom at every other atom, so it is easy to epitaxially grow zinc blende type crystals on diamond type crystals. On the other hand, it is normally difficult to epitaxially grow wurtzite type crystals, which are a type of hexagonal crystals, on diamond type crystals. However, in their (111) plane, wurtzite type crystal structures and zinc blende type crystal structures have the same atom arrangement. This means that a hexagonal, wurtzite type AlN layer can be epitaxially grown on a Si substrate in which the (111) plane is the principal face of the Si substrate (hereinafter, referred to as the (111) Si substrate). This is a conventionally known fact.

*Formation of Lattice Matching Type AlN Layers*

Here, the inventors first noted that if the AlN crystal is sufficiently thin, a (100) AlN layer with a hexagonal, zinc blende type crystal structure is formed on a Si substrate in which the (100) plane is the principal face (hereinafter, referred to as the (100) Si substrate). The AlN layer is of course highly crystalline in its original wurtzite type crystal form, but also when it is a zinc blende type crystal.

Then, by suitably choosing the AlN growth conditions and the plane orientation of the Si substrate, a highly crystalline AlN film can be epitaxially grown on a monocrystalline silicon layer.

On the other hand, the dielectric constant of AlN is 9, which is significantly larger than the dielectric constant of 3.9 of $SiO_2$ formed by thermal oxidation. Thus, using AlN as the material for the gate insulating film, for example, makes it possible to significantly improve the capacitance per unit area, and it is unnecessary to make the AlN film as thin as a $SiO_2$ film for obtaining the same capacitance. That is, the amount of stored electric charge can be improved while direct tunnel leakage of the carriers is suppressed. Thus, AlN films can sufficiently keep up with advancements in the miniaturization and high integration of semiconductor elements.

As documents addressing the fabrication of a group-III nitride crystalline thin film on a Si substrate, there is a sixth document "T. Lei and T. D. Moustakas, J. Appl. Phys. 71, 4934, (1992)", and a seventh document "A. Watanabe, T. Takeuchi, K. Hirosawa, H. Amano, K. Hiramatsu, and I. Akasaki, J. Crystal Growth 128, 391, (1993)."

However, in both documents the AlN film is used as a buffer layer before the formation of a GaN layer, and no attempts of using the AlN film as an element component, such as a gate insulating film, are to be found.

*Formation of Lattice Mismatch Type AlN Layers*

Secondly, the inventors found that under certain conditions, nitride films, such as AlN monocrystalline films, can be epitaxially grown on a Si substrate with lattice mismatching. The epitaxial growth mechanism at this time is still not fully understood, however, it would seem that the so-called surfactant effect is related. The surfactant effect, as disclosed for example in an eighth document, "NIHON BUTSURI GAKKAISHI, vol. 53, p. 244-250 (1998)", is the phenomenon by which the interface energy between a crystalline primer layer and an epitaxially grown layer is reduced by surfactant atoms adhered to the crystalline primer layer. As disclosed in this eighth document, thin film growth is normally divided into the following three growth modes:

a. Frank-van der Merwe growth (F-M growth), in which the crystal is grown layer by layer on the primer.

In this mode, the epitaxially grown substance is grown layer by layer on the crystalline primer layer; one could say that this is the preferred mode for growing a crystalline compound film.

b. Volmer-Weber growth (V-W growth), in which the crystal is grown from the first layer in islands on the primer.

In this mode, the epitaxially grown substance is three-dimensionally grown from the initial stages of the growth on a primer layer; that is, the crystal is grown in islands.

c. Stranski-Krastanov growth (S-K growth), in which the crystal is first grown on the primer in layers, then grown in islands.

In this mode, in the early stages of the growth, the epitaxially grown substance is grown on the primer in monolayers, then after a certain film thickness is exceeded, the crystal starts to be grown three-dimensionally.

Here, when the surface energy per unit area of the crystalline primer layer is $\sigma_s$, and that of the epitaxially grown substance is $\sigma_g$, and the interface energy per unit area therebetween is $\sigma_{in}$, one of the following relationships (1) or (2) normally apply:

$$\sigma_s < \sigma_{in} + \sigma_g \qquad \text{island growth} \qquad (1)$$

$$\sigma_s > \sigma_{in} + \sigma_g \qquad \text{layer growth} \qquad (2)$$

Here, when there is a crystalline primer layer and an epitaxially grown layer which satisfy relationship (1), by reducing the interface energy $\sigma_{in}$ between these two layers, the surfactant attempts to satisfy relationship (2), with the effect that the growth mode shifts from island growth to layer growth.

The modes for growing the crystal in layers during the early stages can be further divided into two types. In the first type, there is little interaction between the epitaxially grown layer and the crystalline primer layer, and the epitaxially grown layer is grown with the lattice constant of the epitaxially grown layer itself (that is, with lattice mismatch) while hardly being affected by the arrangement of the atoms at the surface of the crystalline primer layer. In this case, layer by layer growth of the crystal should continue without strain, regardless of the layer thickness. In the second type, there is a large interaction between the epitaxially grown layer and the crystalline primer layer, and the epitaxially grown layer is grown matching it with the lattice of the surface of the crystalline primer layer. In this case, strain accumulates together with the growth of the epitaxial layer, so a shift is made to island growth when exceeding a certain film thickness.

These documents disclose the effect adhering Au to the Si substrate as a surfactant increases the critical film thickness (film thickness when strain due to lattice matching is relieved by shifting) when a Ge film is grown on the Si substrate. A ninth document, "KOTAI BUTSURI, vol. 29, No. 6 (1994) p. 559-564", discloses the use of Sb as the surfactant in the heteroepitaxial growth of Si/Ge/Si.

The inventors found that when an AlN layer is grown on a Si substrate, the nitrogen atoms N, i.e. an element that is part of the AlN layer, function as a surfactant. The inventors also confirmed that in addition to the surfactant effect, creating certain conditions make it possible to epitaxially grow a crystalline compound film in a state of substantially total lattice mismatch with respect to crystalline primer layer. Then, as will be set forth in later embodiments, it was found that this can be used to provide a dielectric film or a semiconductor film which are free of strain caused by lattice matching.

*First Embodiment*

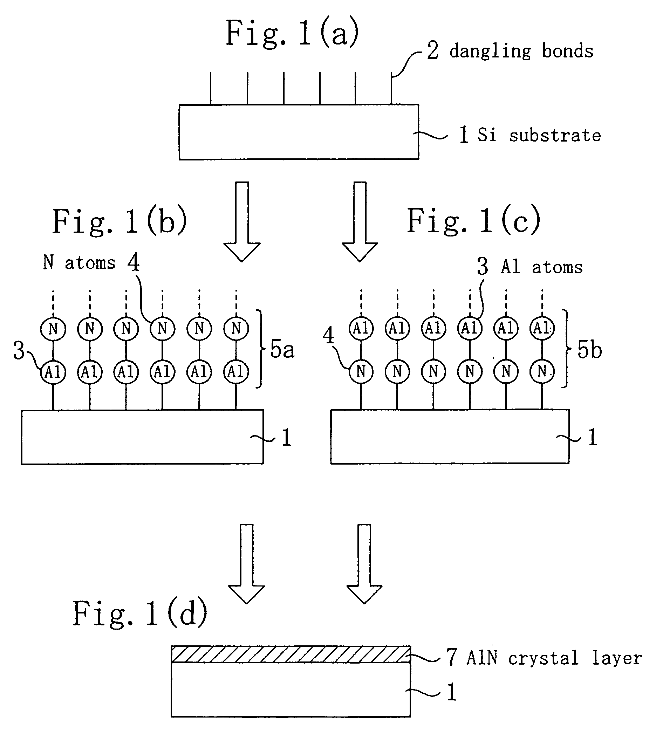

In a first embodiment of the present invention, a method for manufacturing a basic AlN film by molecular beam epitaxy (MBE) using a molecular beam epitaxy device is described. Figs. **1(a)** to **1(d)** are cross sectional views illustrating the procedure for forming an AlN film according to the first embodiment.

As explained layer, it is also possible to form an AlN insulating film on a Si substrate using a device other than the MBE device.

First, in the process shown in Fig. **1(a)**, after cleaning a Si substrate **1** for the fabrication of an element, the Si substrate **1** is soaked in a liquid including hydrogen fluoride (HF) or ammonium fluoride ($NH_4F$), rinsed with water and dried, and then immediately introduced into an MBE device for growing crystals. At this time, the surface of the Si substrate is coated with hydrogen (H) atoms or an extremely thin $SiO_2$ amorphous layer. The principal face of the Si substrate **1** is preferably the (100) plane, however, it can also be the (111) plane or another higher-order plane, or a plane several degrees off of those planes. In the MBE device, the Si substrate **1** is heated to a temperature in the range of 100 to 400°C, thereby removing moisture and/or adsorption gas remaining on the surface of the Si substrate **1**.

Then, the temperature of the Si substrate **1** is raised further and maintained within a range of 800 to 900°C. At this time, the H atoms or the thin $SiO_2$ amorphous layer coating the surface of the Si substrate **1** is removed, thereby leaving behind dangling bonds **2**, as shown in Fig. **1(a)**.

Next, in the step shown in Fig. **1(d)**, with a MBE growth method, material for forming Al atom layers and material for forming N atom layers are supplied in alternation to alternately layer one by one single atom layers of Al atoms and N atoms, thus forming an AlN crystal layer **7** having ten layers.

As this process moves from Fig. **1(a)** to Fig. **1 (d)**, there are two kinds of structures that may be formed depending on the type of atoms at the interface region where the Si substrate **1** is bonded to the AlN crystal layer **7**.

As mentioned above, in either the (100) plane or the (111) plane of the AlN crystal layer **7**, planes formed only by Al atoms **3**, and planes formed only by N atoms **4**, appear alternately. Consequently, there is the case shown in Fig. **1(b)**, in which an interface region **5a** is formed in the AlN crystal layer **7** wherein the Si atoms at the surface of the Si substrate **1** are bonded to the Al atoms **3**, and there is the case shown in Fig. **1(c)**, in which an interface region **5b** is formed in the AlN crystal layer **7** wherein the Si atoms at the surface of the Si substrate **1** are bonded to the N atoms **4**. Which one of these states shown in Fig. **1(b)** and Fig. **1(c)** occurs is determined by whether the Al atom layer forming material is supplied first or the N atom layer forming material is supplied first during the MBE growth.

The properties of the AlN crystal layer **7** are not totally equivalent when the AlN crystal layer **7** has the interface region **5a** shown in Fig. **1(b)** and when it has the interface region **5b** shown in Fig. **1(c)**, but both cases are similar in that the fabricated AlN crystal layer **7** has a structure with good crystallinity.

However, because it is preferable that Al atoms acting as p-type impurities do not migrate into the Si substrate **1**, it is often the case that the state shown in Fig.

1(c) is the preferable of the two. That is, it is safe to say that it is mostly preferable to first supply the raw gas for forming N atom layers.

*Second Embodiment*

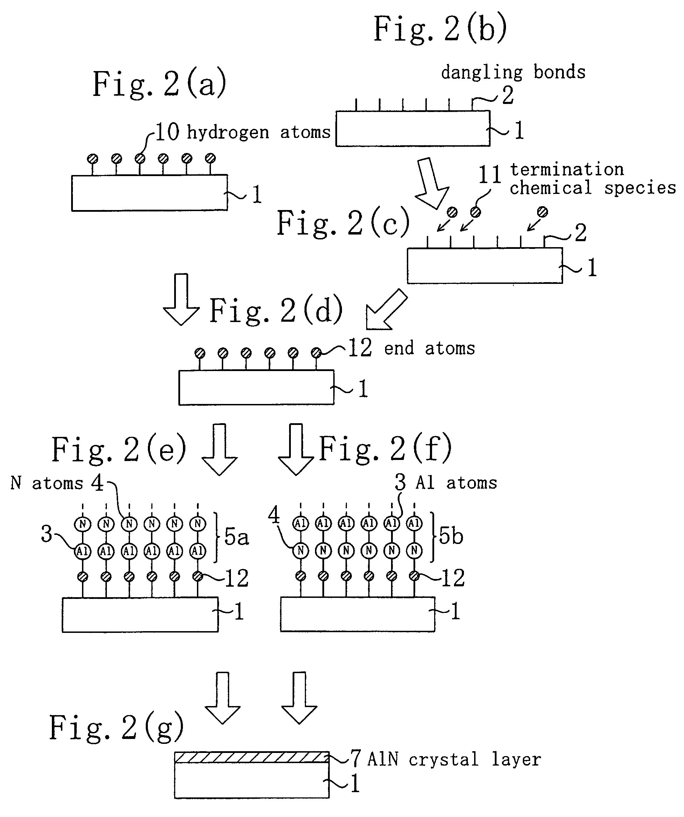

In a second embodiment, a separate example of a method for forming a basic AlN film by molecular beam epitaxy (MBE) using a molecular beam epitaxy device is described. Figs. **2(a)** to **2(g)** are cross sectional views illustrating the procedure for forming an AlN film according to the present embodiment.

First, like in the first process according to the first embodiment, after cleaning the Si substrate **1** for the fabrication of an element, the Si substrate **1** is soaked in a liquid including hydrogen fluoride (HF) or ammonium fluoride ($NH_4F$), rinsed with water and dried, and then immediately introduced into an MBE device for growing crystals. At this time, the surface of the Si substrate is coated with hydrogen (H) atoms or an extremely thin $SiO_2$ amorphous layer. The principal face of the Si substrate **1** is preferably the (100) plane, however, it can also be the (111) plane or another higher-order plane, or a plane set several degrees off of those planes. In the MBE device, the Si substrate **1** is heated to a temperature range of 100 to 400°C, thereby removing moisture and/or adsorption gas remaining on the surface of the Si substrate **1**.

In the first embodiment this was followed by further raising the temperature of the Si substrate **1** and maintaining it in a temperature range of 800 to 900°C, thereby leaving dangling bonds on the Si substrate, and then the AlN crystal layer was formed on those dangling bonds. However, in the present embodiment the termination atoms are left on the surface of the Si substrate **1**, and the AlN crystal layer is formed on those termination atoms.

As shown in Fig. **2(a)**, when the surface of the Si substrate **1** is covered with hydrogen atoms **10**, this is followed by stopping the rise in temperature of the substrate near 500°C.

Then, as shown in Fig. **2(d)**, the hydrogen atoms **10** are left remaining as the termination atoms **12** of the dangling bonds.

On the other hand, when the surface of the Si substrate **1** is covered with a $SiO_2$ amorphous layer, or other chemical species or thin layer, the Si substrate **1** is maintained within a temperature range of 800 to 900°C. At this time, the other chemical species or thin $SiO_2$ amorphous layer serving as the surface covering is removed from the surface of the Si substrate **1**. Then, as shown in Fig. **2(b)**, dangling bonds **2** are left behind on the surface of the Si substrate **1**. Next, as shown in Fig. **2(c)**, termination chemical species **11** are supplied to the dangling bonds **2** on the Si substrate **1**.

As shown in Fig. **2(d)**, the result is that the chemical species **11** are kept as the termination atoms **12**, terminating the dangling bonds **2**. For the termination chemical species **11** used at this time, one can be chosen from the group consisting of hydrogen (H), Mg, sulfur (S), nitrogen (N), or aluminum (Al), for example.

Then, as mentioned above, in either case AlN is epitaxially grown after the dangling bonds on the surface of the Si substrate **1** are terminated by the termination atoms **12**.

Then the AlN crystal layer **7** is formed in the step shown in Fig. **2(g)**. Here, as the process moves from Fig. **2(d)** to Fig. **2(g)**, as explained in the first embodiment, whether the atoms at the bottom end of the interface region of the AlN crystal layer **7** are Al or N is determined by which type of raw gas is supplied first during the MBE growth, but whether it is easier for the Al atoms **3** or for the N atoms **4** to attach to this bottom end may depend on the type of termination atoms **12** on the surface of the Si substrate **1**.

Then, in either the (100) plane or the (111) plane of the AlN crystal layer **7**, planes formed only by Al atoms **3**, and planes formed only by N atoms **4**, appear in alternation. Consequently, there is the case shown in Fig. **2(e)**, in which an interface region **5a** is formed wherein in the AlN crystal layer **7** the termination atoms **12** at the surface of the Si substrate **1** are bonded to the Al atoms **3**, and there is the case shown in Fig. **2 (f)**, in which an interface region **5b** is formed wherein in the AlN crystal layer **7** the termination atoms **12** at the surface of the Si substrate **1** and the N atoms **4** are conjoined, is formed in the AlN crystal layer **7**. The properties of the AlN crystal layer **7** when it has the interface region **5a** shown in Fig. **2(e)**, and when it has the interface region **5b** shown in Fig. **2(f)**, are not completely equivalent, but in both cases the AlN crystal layer **7** has a structure with good crystallinity.

However, also in the present embodiment, because it is not preferable for Al atoms, which act as p-type impurities, to migrate into the Si substrate **1**, it is often the case that the state shown in Fig. **2(f)** is preferable. That is, one could say that it is mostly preferable to first supply the raw material for forming the N atom layers.

According to the method of the present embodiment, in the step shown in Fig. **2(d)**, the AlN crystal is grown after the dangling bonds on the surface of the Si substrate **1** have been terminated by the termination atoms **12**, so in comparison to the method of the first embodiment, there is the benefit that the density of the interface states in the formed AlN crystal layer **7** can be more reliably reduced.

Moreover, in the present embodiment a single atom layer made of termination atoms **12** is interposed between the AlN crystal layer 5 and the Si substrate **1**, so there is the advantage that suitably selecting the chemical species for configuring the termination atoms **12** makes it possible to more effectively suppress the migration of Al atoms into the Si substrate **1**.

*Third Embodiment*

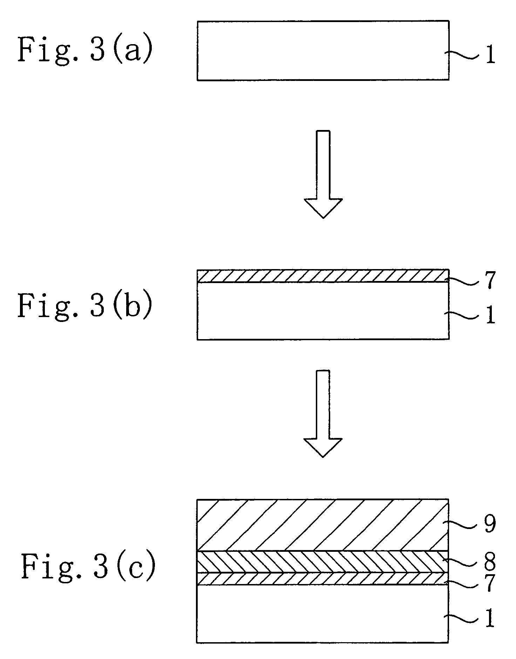

The third embodiment describes a method for forming a layered film when a layered structure in which a separate crystal layer is layered on the AlN crystal layer is used as the gate insulating film of a 3 terminal- or 4 terminal-type field effect transistor functioning as a MFISFET, for example. Figs. **3(a)** to **(c)** are cross sectional views showing the process for forming a layered film having an AlN film and a dielectric thin film according to the third embodiment.

First, in the steps shown in Figs. **3(a)** and **3(b)**, the fabrication process according to either of the above-mentioned first or second embodiments is used to form the AlN crystal layer **7** on the Si substrate **1**.

Then, in the step shown in Fig. 3(c), a dielectric thin film **8** having crystallinity is formed on the AlN crystal layer **7**. It is preferable that for the dielectric material constituting the dielectric thin film **8**, a material is used that has a dielectric constant ($\varepsilon r$) that is at least larger than the dielectric constant of 3.9 of a directly oxidized $SiO_2$ film. A polysilicon film **9** for the gate electrode is then formed on the dielectric thin film **8**.

The material for forming the dielectric thin film **8** preferably has a high degree of crystallinity, but can also be amorphous. To fabricate the dielectric thin film **8** having a high crystallinity, in the case of the (111) Si substrate, the (0001) plane of a hexagonal structure (wurtzite-type structure) matches the (111) plane of the Si substrate, so it is preferable that to use a dielectric material with a hexagonal structure. Additionally, in the case of the (100) Si substrate, the (100) plane of a cubic structure (zinc blende type structure) matches the (100) plane of the Si substrate, so it is preferable to use a dielectric material with a cubic structure. However, if the dielectric thin film is extremely thin, it is possible to hold the crystal structure of the Si substrate **1** as is, so there is no limitation to the above configurations.

Furthermore, when the dielectric thin film **8** is crystalline, it is preferable that the lattice constant thereof is close to the lattice constant of the AlN crystal layer **7** or the lattice constant of the Si substrate **1**. More specifically, $CeO_2$, which has a lattice mismatch percentage of -0.37% with Si, $ZrO_2$, which has a lattice mismatch percentage of -5.4% with Si, or a crystal mixture thereof, for example, are conceivable as examples of a dielectric material for forming the dielectric thin film **8**.

The dielectric material for forming the dielectric thin film **8** can also be MgO, for example, which has a lattice mismatch percentage of -4.5% with AlN.

By using a material such as the above to form the dielectric material **8**, the dielectric constant ($\varepsilon r$) of the entire layered structure of the AlN crystal layer **7** and the dielectric thin film **8** together can be set to two or more times the dielectric constant of a $SiO_2$ film. This means that the entire layered structure of the AlN crystal layer **7** and the dielectric thin film **8** together can be used as the gate insulating film to achieve a gate insulating film having a high capacitance per unit area.

It is also possible to use a crystalline thin film having not only a large dielectric constant but also ferroelectric properties for the dielectric thin film **8**. In this case, examples of ferroelectric material include barium titanate ($BaTiO_3$), PZT ($PbZrO_3$-$PbTiO_3$), and PLZT (oxide including Pb, La, Zr, and Ti). Here, by forming a ferroelectric material on the highly crystalline AlN crystal layer **7**, the crystallinity of the dielectric thin film **8** having ferroelectric properties can be made significantly higher than when the dielectric thin film **8** is formed on a thin film having an amorphous structure. The result is that the dielectric constant of the dielectric thin film **8** with high crystallinity and ferroelectric properties can be markedly increased, and the dielectric constant ($\varepsilon r$) of the entire layered structure including the AlN crystal layer **7** and the dielectric thin film **8** becomes significantly higher.

At this time the highly crystalline AlN crystal layer **7** functions as a buffer layer when layering the dielectric thin film **8**, which either has a higher dielectric constant than AlN or has ferroelectric properties, onto the Si substrate **1**.

Then, because the AlN crystal layer **7** has a high crystallinity and is compact, the diffusion of impurities from the dielectric thin film **8**, which is made from a highly dielectric material that includes heavy metals, for example, or a ferroelectric material, can be suppressed. Also, because the AlN crystal layer **7** itself has a high dielectric constant, the proportion of the voltage applied to the gate electrode that gets applied to the AlN crystal layer **7** functioning as a buffer layer can be reduced to less than one half of the voltage when a $SiO_2$ film is used as a buffer layer.

Also, because the AlN crystal layer **7** is highly crystalline, the dielectric thin film **8** formed on the AlN crystal layer **7** is highly orientated or crystallized reflecting the crystallinity of the AlN crystal layer **7**, and thus an even higher dielectric constant can be achieved, or more stable remanent polarity holding properties can be obtained.

*Fourth Embodiment*

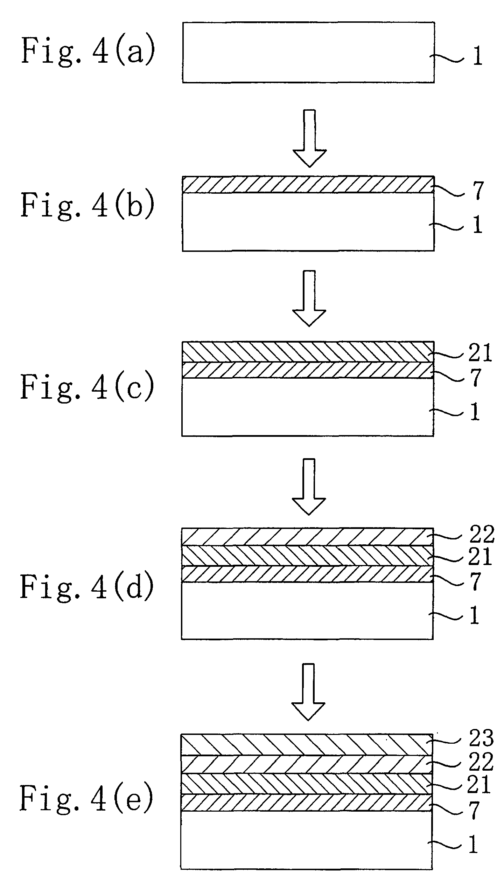

A fourth embodiment describes a method for forming a layered film when a layered structure, in which separate crystal layers are layered above and below the AlN crystal layer, is used as the gate insulating film of a 3 terminal- or 4 terminal-type field effect transistor functioning as a MFMISFET, for example. Figs. **4(a)** to **4(e)** are cross sectional views showing the steps for forming the layered film according to the fourth embodiment, which includes an AlN crystal layer, a crystalline dielectric thin film, a conductive thin film, and a ferroelectric film.

First, in the process steps shown in Figs. **4(a)** and **4(b)**, the fabrication process of either of the above-mentioned first or second embodiments is used to form the AlN crystal layer **7** on the Si substrate **1**.

Next, in the process step shown in Fig. **4(c)**, a first conductive thin film **21** having crystallinity is formed on the AlN crystal layer **7**. CoSi$_2$, for example, is a possible material for configuring the crystalline, first conductive film **21**.

Then, in the process step shown in Fig. **4(d)**, a crystalline dielectric thin film **22** made from a highly dielectric or ferroelectric material is formed on the first conductive thin film **21**. Possible materials for configuring the crystalline dielectric thin film **22** include barium titanate (BaTiO$_3$), PZT (PbZrO$_3$-PbTiO$_3$), and PLZT (oxide including Pb, La, Zr, and Ti), for example.

Next, in the process step shown in Fig. **4(e)**, a second conductive thin film **23** is formed on the crystalline dielectric thin film **22**. CoSi$_2$, for example, is a possible material for forming the crystalline, second conductive film **23**.

The first conductive thin film **21** and the second conductive thin film **23** here are provided above and below the crystalline dielectric thin film **22**, but it is also possible to provide only the upper or lower of the conductive thin films.

By patterning the layered film of the present embodiment to form a gate structure and source and drain regions, the crystalline dielectric thin film **22** can be made to function as the floating gate electrode of a nonvolatile semiconductor memory device. Then, the charge stored on the crystalline dielectric thin film **22** can be moved to the first conductive thin film **21** or the second conductive thin film **23**, or between both, to erase or write data.

*Fifth Embodiment*

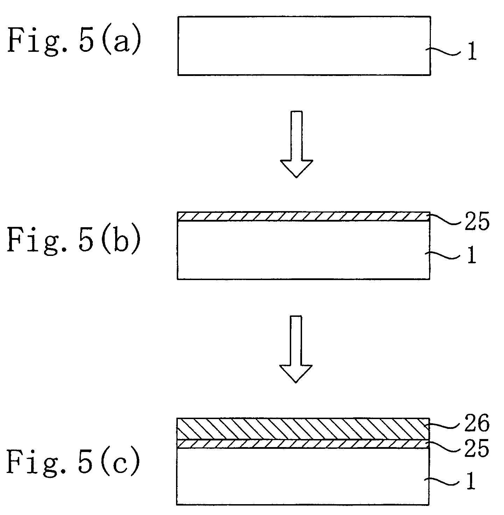

A fifth embodiment describes a method for forming a layered film when a layered structure, in which a separate amorphous layer is layered on the AlN crystal layer, is used as the gate insulating film of a 3 terminal- or 4 terminal-type field effect transistor functioning as a MFISFET, for example. Figs. **5(a)** to **5(c)** are cross sectional views showing the steps for forming the layered film including the AlN film and an amorphous layer according to the fifth embodiment.

First, in the process step shown in Fig. **5(a)**, after cleaning a Si substrate **1** for the fabrication of an element, the Si substrate **1** is soaked in a liquid including hydrogen fluoride (HF) or ammonium fluoride (NH$_4$F), rinsed with water and dried, and then immediately introduced into a device for conducting nitrogenation and MBE growth. At this time, the surface of the Si substrate is coated with hydrogen (H) atoms or an extremely thin SiO$_2$ amorphous layer. The principal face of the Si substrate **1** is preferably the (100) plane, however, it can also be the (111) plane or another higher-order plane, or a plane several degrees off of those planes. In the device, the Si substrate **1** is heated to a temperature in the range of 100 to 400°C, thereby removing moisture and/or adsorption gas remaining on the surface of the Si substrate **1**.

Then, the temperature of the Si substrate **1** is raised further and maintained within a range of 800 to 900°C. At this time, the H atoms or the thin SiO$_2$ amorphous layer coating the surface of the Si substrate **1** is removed.

Next, in the step shown in Fig. **5(b)**, dried NH$_3$ gas or N$_2$0 gas, or radical activated nitrogen gas, is supplied to the Si substrate **1** to nitrogenize the Si on the surface of the Si substrate **1**, thereby forming a noncrystalline silicon nitride layer **25** made of a silicon nitride compound such as Si$_3$N$_4$. In this case the clean, smooth Si substrate surface is either irradiated with excited species of nitrogen molecules or atoms generated by high-frequency cells or helicon plasma cells, or irradiated with ammonia, or derivative molecules or ions thereof, activated by applying extreme heat, to directly nitrogenize the Si. It is preferable that the silicon nitride layer **25** is extremely thin and only a single molecule to several molecules thick, is non-amorphous, and its highly periodic properties are maintained.

Then, in the process step shown in Fig. **5(c)**, a crystalline AlN thin film **26** is layered by MBE growth. At this time, although the silicon nitride layer **25** serving as the primer for the AlN thin film **26** is amorphous, the silicon nitride layer **25** maintains the regularity of the crystal structure of the Si substrate **1**, because due silicon nitride layer **25** is extremely thin and the new nitride film is not deposited by CVD, for example, but is instead formed by nitriding the Si substrate **1**. For that reason, the AlN thin film **26** formed on the silicon nitride layer **25** is substantially epitaxially grown reflecting the crystal structure in the Si substrate **1**, and thus a high degree of crystallinity can be achieved.

Next, due to the presence of the silicon nitride layer **25**, the dangling bonds at the surface of the Si substrate **1** are terminated by nitrogen, and the density of interface states becomes extremely small. This means that using this layered film of an AlN thin film **26** and a silicon nitride layer **25** as the gate insulating film of a field effect transistor achieves a gate insulating film that has a high dielectric constant and high breakthrough properties.

*Sixth Embodiment*

The sixth embodiment describes a method for relieving strain in the AlN film caused by lattice mismatch between the AlN film and the Si substrate. The present embodiment is explained applying the process steps according to the aforementioned first through fifth embodiments, so figures showing these process steps has been omitted.

In the present embodiment, as in the abovementioned embodiments, after cleaning the Si substrate for the fabrication of an element, the Si substrate is soaked in a liquid including hydrogen fluoride (HF) or

ammonium fluoride (NH$_4$F), rinsed with water and dried, and then immediately introduced into a MBE device for growing crystals. At this time, the surface of the Si substrate is coated with hydrogen (H) atoms or an extremely thin SiO$_2$ amorphous layer. The principal face of the Si substrate is preferably the (100) plane, however, it can also be the (111) plane or another higher-order plane, or a plane several degrees off of those planes. In the MBE device, the temperature of the Si substrate is raised to remove moisture and/or adsorption gas remaining on the surface of the Si substrate. Then, the temperature of the Si substrate is further raised and the H atoms or the thin SiO$_2$ amorphous layer coating the surface of the Si substrate **1** is removed.

Then, as described in the first through fifth embodiments, an AlN film is formed on the Si substrate either directly or via a thin nitride film. At this time, with the MBE growth described in the first through fifth embodiment, oxygen, hydrogen, or sulfur impurities for example, are continually added to the AlN crystal layer **7** (or the AlN thin film **26**). Oxygen or hydrogen is supplied from the gas valve or gas cell disposed in the MBE device. Here, the oxygen or the hydrogen molecules can be supplied as they are, or activated and supplied as high frequency treated radicals, ions, or atoms. Sulfur can be supplied using a normal K-cell, or it can be supplied in a cracked state using a valve cracking cell, for example.

The above added elements are added individually or as mixtures of two or more types of atoms. Furthermore, the added amount of these elements is the dopant level, which should be in the range of $1\times10^{15}$ cm$^{-3}$ to $1\times10^{20}$ cm$^{-3}$.

When the AlN layer including the above additives is used as the gate insulating film for a variety of transistors, these additives do not contribute to current leakage, which is a cause of deteriorated electrical properties, and do not deteriorate the insulating properties of the gate insulating film.

Also, adding impurities, particularly the above-mentioned impurities, to the AlN layer at a range or $1\times10^{15}$ cm$^{-3}$ to $1 \times 10^{20}$ cm$^{-3}$ can relieve strain resulting from a lattice mismatch caused by the different lattice constants of the Si substrate and the AlN layer. The result is that the introduction of crystal defects in the AlN layer, such as dislocations, are suppressed, and the crystallinity of the AlN layer is improved. Because strain is relieved in this manner, the deterioration of properties that occurring over time and the advancement of deterioration due to heating processes can be suppressed, and it is possible to improve the reliability of a semiconductor element in which an AlN layer forms the gate insulating film or a part of the gate insulating film.

Contrary to the above method for relieving strain in the AlN layer, it is also possible to increase the dielectric constant of the AlN layer by tilting the principal face of the Si substrate against the (100) plane to increase the strain within the AlN layer.

*Seventh Embodiment*

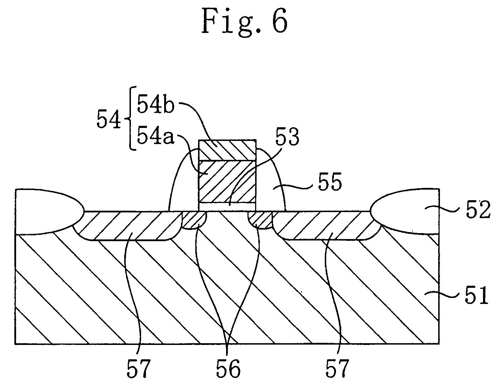

The seventh embodiment describes the structure of a field effect transistor, which is one type of semiconductor elements, having a gate insulating film made of the AlN layer (the AlN crystal layer **7**, the AlN thin film **26**, or the layered film of the AlN layer and another thin film) formed with the methods illustrated in the first, second, third, or fifth embodiments. Fig. **6** is a cross sectional view of a field effect transistor according to the seventh embodiment.

As shown in Fig. **6**, a LOCOS film **52**, which is an insulating film for separating elements, is formed on a Si substrate **51**. Then, a gate insulating film **53**, which is made of only the AlN layer or the AlN layer and another thin film; a gate electrode **54** made of a low resistant polysilicon layer **54a** and silicide layer **45b**; and insulating side walls **55**, which are made of a silicon oxide film and formed on both lateral faces of the gate electrode **54**, are provided on the active region surrounded by the LOCOS film **52** of the Si substrate **51**. Furthermore, low concentration source/drain regions **56** (LDD region) sandwiching the region (channel region) positioned directly below the gate insulating film **53**, and high concentration source/drain regions **57** formed at the outer side of the low concentration source/drain region **56**, are provided in the Si substrate **1**. The impurities in the low concentration source/drain regions **56** and the high concentration source/drain regions **57** are p-type impurities (such as boron) when the field effect transistor is of the p-channel type, and n-type impurities (such as arsenic or phosphorus) when the field effect transistor is of the n-channel type.

As mentioned above, by making the gate insulating film of a 3 terminal- or 4 terminal-type field effect transistor a highly crystalline AlN layer (or layered film having an AlN layer and another thin film), it is possible to significantly improve the capacitance per unit area of the gate insulating film over that of a SiO$_2$ film that has been formed by thermal oxidation. Consequently, in a case wherein both have the same capacitance, the gate insulating film can be given a larger film thickness when it is an AlN layer than when it is a SiO$_2$ film, so in the gate insulating film there is hardly any leakage due to direct tunneling of the carriers. Also, the AlN layer can maintain good insulating properties because AlN has a large band discontinuity, and there are only very few impurities or defects in the AlN layer that generate carriers.

Furthermore, due to the resemblance in crystal structure and the nearness of the lattice constants of AlN and Si, a crystalline AlN layer is grown on the crystalline Si substrate, and thus the occurrence of dangling bonds at the interface region with the Si substrate can be inhibited, and the density of the interface states can be kept equal to or below that of a SiO$_2$ film formed by direct oxidation.

*Modified Examples of the First to Seventh Embodiments*

In the above embodiments the AlN layer (AlN crystal layer **7** or AlN thin film **26**) was formed by MBE, however, it is also possible to form a crystalline AlN layer using chemical vaporization deposition (CVD), metal organic vapor phase epitaxy (MOVPE), hydride vapor phase epitaxy (HVPE), or sputtering, for example.

Also, in the above embodiments, the AlN layer was used as the gate insulating film of a MOS transistor, but the AlN layer can also be used as the capacity insulating film of a MIS capacitor or a MIM capacitor.

Furthermore, an AlN layer having good crystallinity can be grown not only on Si substrates but also on GaAs substrates.

*Eighth Embodiment*

The present embodiment describes an example in which nitrogen atoms N are used as the surfactant to epitaxially grow an AlN crystal layer on a Si substrate in a state of lattice mismatch.

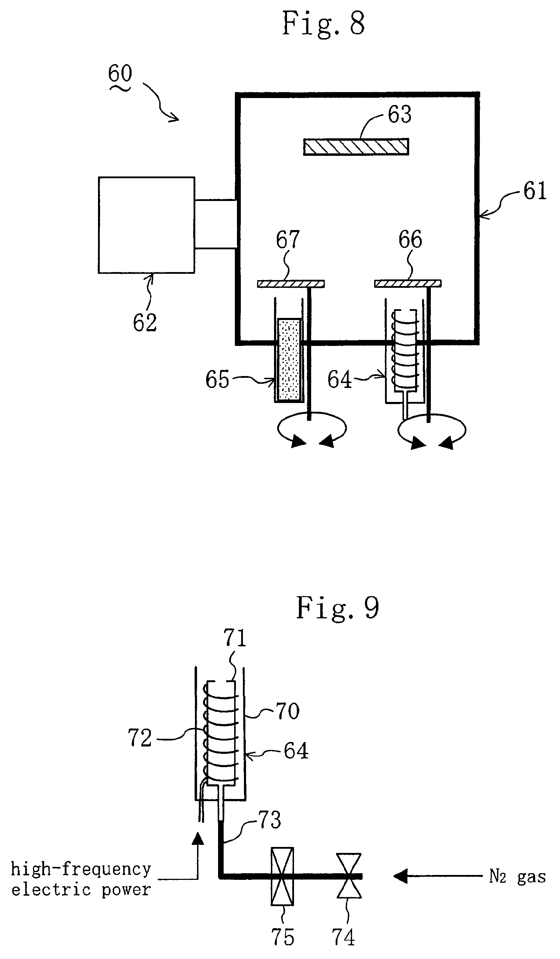

Fig. **8** is a cross sectional view schematically showing the configuration of a MBE device **60** used in the present embodiment. As shown in the Fig. **8**, the MBE device **60** is provided with a vacuum vessel **61**, a vacuum pump **62** for maintaining a vacuum within the vacuum vessel **61**, a plasma cell **64** and a K-cell **65** attached to a portion of the vacuum vessel **61**, and shutters **66** and **67** for controlling the release of epitaxial substances from the plasma cell **64** and the K-cell **65**, respectively. The plasma cell **65** is configured such that it releases radical nitrogen, which is made by turning nitrogen into a plasma, into the vacuum vessel **61**, and the K-cell **65** is configured such that it releases Al atoms into the vacuum vessel **61**. Moreover, the MBE device **60** is configured such that it can epitaxially grow an AlN crystal layer by alternately growing one layer at a time of the radical nitrogen and the Al atoms released from the plasma cell **64** and the K-cell **65** (Knudsen Cell) onto a substrate **63**, that is, the work piece disposed in the vacuum vessel **63**.

Fig. **9** is a cross sectional view showing the configuration of the plasma cell **64**. As shown in Fig. **9**, the plasma cell **64** is provided with a case **70** for mechanically holding the cell, a PBN (Pyrolytic Boron Nitride) crucible **71** disposed in the case **70**, and a coil **72** wound around the perimeter of the PBN crucible **71**. The end of the PBN crucible **71** is provided with an opening for supplying the radicalized nitrogen, and the bottom of the PBN crucible **71** opens into a gas lead pipe **73** for supplying $N_2$ gas. The gas lead pipe **73** is connected to a $N_2$ gas supply device (gas cylinder, for example) via a valve **74**. A mass flowmeter **75** for controlling the flow of the $N_2$ gas is usually attached to the gas lead pipe **73**.

The MBE device **60** is configured such that the $N_2$ gas introduced into the PBN crucible **71** is turned into a plasma and the radical nitrogen is supplied onto the substrate **63** by applying high frequency electric power to the coil **72** wrapped around the circumference of the PBN crucible **71**. In the K-cell **65**, an Al material is heated to release vaporized Al atoms.

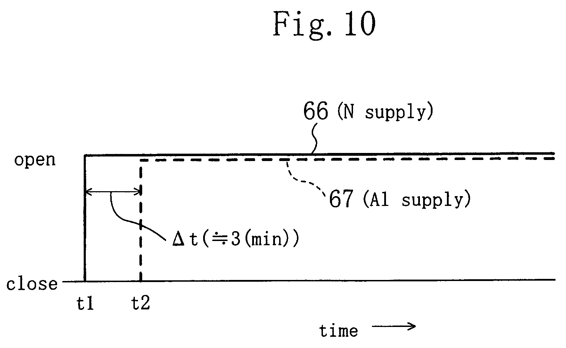

Fig. **10** is a diagram showing the timing of the opening and closing of the shutter **66** of the plasma cell **64** and the shutter **67** of the K-cell **65** when the AlN crystal layer is epitaxially grown. First, the shutter **66** of the plasma cell **64** is opened at a certain timing t1 to release radical nitrogen, after which the shutter **67** of the K-cell **65** is opened at a timing t2 to release Al atoms. The time difference $\Delta t$ here between the timing t1 and the timing t2 is approximately 3 minutes, and during that time $\Delta t$, the radical nitrogen covers the surface of the Si substrate and functions as a surfactant with respect to subsequent epitaxial growth in a state of lattice mismatch. This is followed by both shutters **66** and **67** being open to continually release radical nitrogen and Al atoms to alternately form single monolayers of N layers and Al layers on the substrate, thus epitaxially growing the AlN crystal layer. The shutters **66** and **67** can be opened and closed at intervals for forming single monolayers of N layers and Al layers by alternately switching the shutters on and off. Thus, N layers and Al layers can be alternately fabricated layer by layer with even greater precision.

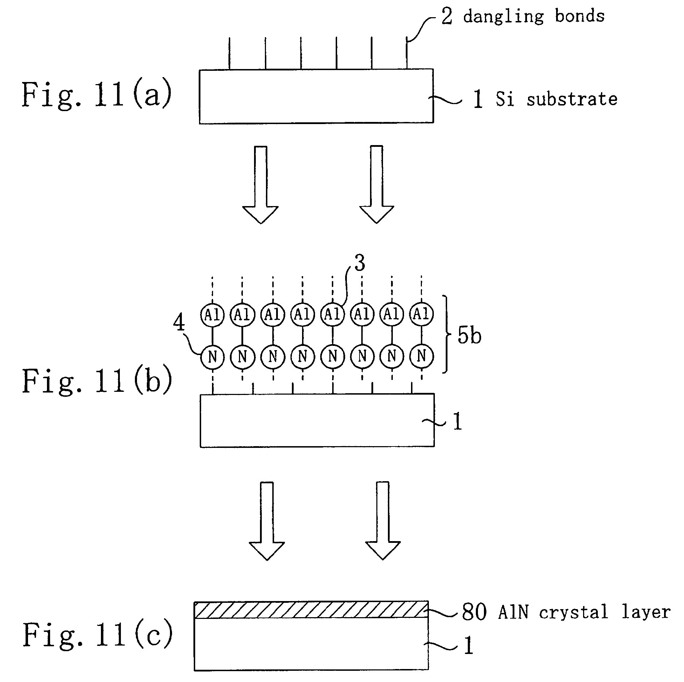

Figs. **11(a)** to **11(c)** illustrate the process for epitaxially growing an AlN crystal layer according to the present embodiment. First, as shown in Fig. **11(a)**, when the Si substrate **1** is heated in an ultra vacuum atmosphere to clean the principal face of the Si substrate **1**, dangling bonds **2** are formed on the surface of the Si substrate. At this time, the principal face of the Si substrate **1** has a period structure that is 7 × 7 large (7 × 7 rebuilt structure) when the period of a unit cell of the (111) plane of the diamond structure of Si is taken as a unit "1."

Next, as shown in Fig. **11(b)**, first the shutter **66** of the plasma cell **64** is opened to supply radical nitrogen (N) onto the principal face of the Si substrate **1**, thereby forming an N layer on the principal face of the Si substrate **1**. Then, the shutter **67** of the K-cell **64** is opened to form an l layer on the N layer. At this time, the mechanism of the epitaxial growth of the AlN crystal layer according to the present embodiment corresponds to the first embodiment, and like the first embodiment, it is conceivable that the N atoms **4** do not adhere to the dangling bonds formed at the top of the Si single crystal surface of the Si substrate **1** at a 1:1 ratio, but that the N atoms **4** also migrate into the Si crystal lattice in addition to adhering to the dangling bonds. Then, the following layer of Al atoms are bonded to the N atoms **4** of the initial N layer to form a single monolayer of the Al layer.

As shown in Fig. **11(c)**, this is followed by the formation of an AlN crystal layer **80** by alternately forming single monolayers of N layers and Al layers, and from the beginning of the epitaxial growth the lattice distance of the AlN crystal layer **80** is not matched with the lattice distance of the Si substrate **1** acting as the primer. That is, epitaxial growth continues while maintaining a lattice distance substantially similar to the usual lattice constant of AlN crystals.

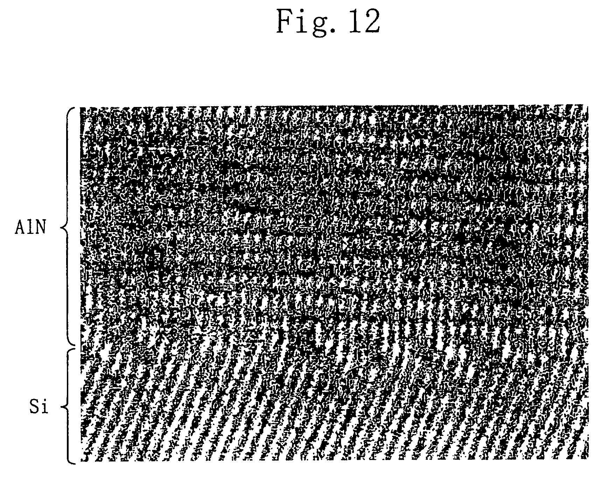

Fig. **12** shows a TEM image of a vertical cross section of the layered structure of Si substrate and AlN crystal layer according to the present embodiment. It can be seen from Fig. **12** that at the boundary between the Si substrate and the AlN crystal layer, the 5 lattice of the AlN crystal layer is in contact with the 4 lattice of the Si substrate, and that the AlN crystal layer has been epitaxially grown with a crystal lattice which does not match the crystal lattice of the Si substrate serving as the primer.

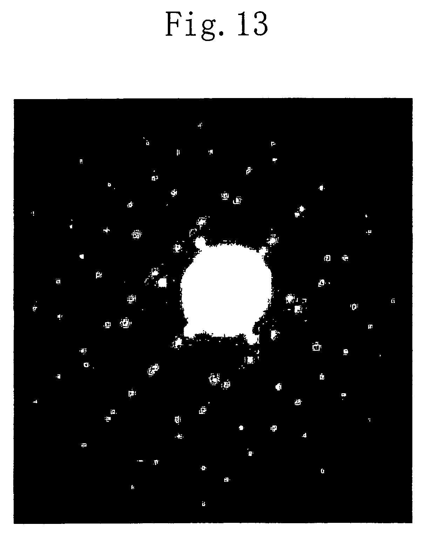

Fig. **13** shows an electron beam diffraction image of the AlN crystal layer epitaxially grown in the present embodiment. As shown in Fig. **13**[2], an (0001) plane pattern of the AlN crystal layer has been obtained. That is, it was found that an AlN crystal layer with good crystallinity and the (0001) plane as its principal face can be obtained on the Si substrate, for which the (111) plane is the principal face. Moreover, the (111) plane of the Si substrate primer and the (0001) plane of the AlN crystal layer are both dense planes, and in terms of crystallography are substantially identical planes. Thus, one could say that the AlN crystal layer grows inheriting information on the crystal orientation of the Si substrate primer, while being epitaxially grown mismatched with the crystal lattice of the Si at the interface with the Si substrate primer, that is, in a crystal lattice position substantially matching its own original crystal structure.

On the other hand, even though the technology disclosed in the aforementioned eighth and ninth documents, may theoretically allude to the possibility of using the surfactant effect to conduct epitaxial growth in a state of lattice mismatch, these documents disclose that in epitaxial growth actually obtained using the surfactant effect, there are regions with lattice matching and there is a critical film thickness at which strain is relieved. That is, it is likely that simply using the surfactant effect will not always achieve epitaxial growth in the state of substantially total lattice mismatch as in the present embodiment. The following explores the logical reasons behind why the epitaxial growth of the present embodiment was achieved.

It would seem that the reason why this monocrystalline layer was obtained by epitaxial growth in a state of substantially total lattice mismatch is due to the surfactant effect mentioned above, but in this case it is also assumed that epitaxial growth with lattice mismatch was possible due to the fact that the bonding strength between the Al atoms and the N atoms is stronger than that between the Si atoms. That is, it is logical to think that in addition to the surfactant effect, since the bonding strength between the epitaxially grown atoms is stronger than the bonding strength between the atoms in the primer crystal layer, the influence of the crystal lattice of the primer can be superseded yet the original lattice constant of its crystal maintained during epitaxial growth. In the case of the present embodiment, the elastic constant of the AlN crystal is $C_{11}=345$, $C_{12}=125$, $C_{13}=120$, $C_{33}=394$, and $C_{44}=118$, and the elastic constant of the Si crystal is $C_{11}=165.7$, $C_{12}=50.6$, and $C_{44}=79.4$. Consequently, the bonding strength between the atoms of the AlN crystal layer is much larger than the bonding strength between the atoms of the Si substrate, and it seems that this difference in bonding strength between atoms has contributed to achieving the technology for epitaxial growth with lattice mismatch according to the present embodiment.

Thus, considering the fact that epitaxial growth with lattice mismatch is made possible because the grown layer has a higher bonding strength between atoms than does the crystal layer of the primer, it can be seen that crystal films that can be epitaxially grown with lattice mismatch according to the present invention are not limited to AlN crystal layers such as in the present embodiments. In the present embodiments, an AlN crystal layer was used as the nitride film epitaxially grown on the crystal layer of the primer, however, the elastic constants of a GaN crystal, for example, are $C_{11}=296$, $C_{12}=130$, $C_{13}=158$, $C_{33}=267$, and $C_{44}=24.1$, and it can be seen that they are much larger than the elastic constants of a Si crystal. It is known that normally nitrides have a large bonding strength between their atoms, and that group-III element nitrides (AlN, GaN, AlGaN, BN, or InN, for example) form favorable crystal structures. Consequently, epitaxial growth in a state of lattice mismatch can be performed by using the surfactant effect of N atoms while forming various nitride films onto a crystal layer that has a smaller bonding strength between atoms than the nitride film.

Moreover, even with a compound crystal layer with compositional components that are elements other than nitrogen and having the surfactant effect, it is possible to obtain an epitaxially grown layer which is in a state of lattice mismatch with the crystal layer of the primer but has inherited information relating to the crystal orientation of the crystal layer of the primer, by epitaxially growing the compound crystal layer using the same method as the present embodiment on a primer crystal layer with a smaller bonding strength between its atoms than the compound crystal layer,

INDUSTRIAL APPLICABILITY

The layered structure and method for manufacturing the same according to the present invention can be used in devices such as MIS transistors, MFIS transistors and capacitors mounted in an IC, for example.

Furthermore, the semiconductor element of the present invention can be used as a device such as a MIS transistor, MFIS transistor, or capacitor, for example.

## Claims

1. A layered structure, comprising:

    a substrate having a crystal layer, and
    a crystalline compound film, which is epitaxially grown on a principal face of the crystal layer, whose orientation follows the orientation of the crystal layer, which has a crystal lattice that does not match a lattice of the crystal layer, and which has a larger bonding strength between atoms than the crystal layer.

2. The layered structure according to claim 1, wherein the crystalline compound film is a group-III element nitride film.

3. The layered structure according to claim 1 or claim 2, wherein the crystal layer is a Si crystal layer, and the principal face of the Si crystal layer is the (111) plane.

4. The layered structure according to claim 3, wherein the crystalline compound film is an AlN film.

5. A method for manufacturing a layered structure, comprising:

    alternately repeating a step (a), wherein a first atom layer of either a group-III element atom layer or a N atom layer is formed on a principal face of a crystal layer of a substrate; and
    a step (b), wherein a second atom layer of the other of the group-III element atom layer or the N atom layer is formed on the first atom layer; thereby epitaxially growing a crystalline group-III element nitride film on the crystal layer.

6. The method for manufacturing a layered structure according to claim 5, wherein in the step (a) a N atom layer is formed, and
    wherein in the step (b) a group-III element atom layer is formed to epitaxially grow a crystalline group-III element nitride film on the crystal layer, wherein the crystalline group-III element nitride film has a crystal lattice not matching the crystal lattice of the principal face of the substrate.

7. The method for manufacturing a layered structure according to claim 6, wherein the crystal layer is a Si crystal layer, and
    wherein the principal face of the Si crystal layer is the (111) plane.

8. The method for manufacturing a layered structure according to claim 7, wherein in the step (b) an Al atom layer is formed, thereby forming an AlN film as the nitride film.

9. The method for manufacturing a layered structure according to any of claims 6 to 8, wherein deposition of the N atom layer is performed by a molecular beam epitaxy (MBE) method, in which radical nitrogen made by turning nitrogen gas into a plasma is supplied to the principal face of the crystal layer.

10. The method for manufacturing a layered structure according to claim 11, wherein the nitrogen gas is turned into a plasma using a plasma cell.

11. A method for manufacturing a layered structure, comprising:

    a step (a), wherein a principal face of a Si crystal layer of a substrate is exposed to an atmosphere including one of nitrogen, hydrogen, sulfur and magnesium, to terminate dangling bonds on the primary surface of the semiconductor substrate; and
    a step (b), wherein a crystalline AlN layer is formed on the Si crystal layer.

12. The method for manufacturing a layered structure according to claim 11, further comprising a step before the step (b), wherein a principal face portion of the Si crystal layer is nitrogenized to form a silicon nitride layer; and
    wherein in the step (b), a crystalline AlN layer is formed on the silicon nitride layer.

13. The method for manufacturing a layered structure according to claim 12 or claim 13, wherein in step (b) at least one of oxygen, hydrogen and sulfur is added to the AlN film to relieve strain in the AlN layer resulting from lattice mismatch with the Si crystal layer.

14. A semiconductor element, comprising:

    a substrate having a semiconductor layer;
    an insulating film provided on the semiconductor layer and having an AlN layer; and
    an electrode provided on the gate insulating film and made from a conductor.

15. The semiconductor element according to claim 14, wherein the AlN layer is a monocrystalline layer epitaxially grown on the semiconductor layer.

16. The semiconductor element according to claim 15, wherein the semiconductor layer is a Si crystal layer;
    wherein the principal face of the semiconductor layer is the (111) plane; and
    wherein the AlN layer is a dense hexagonal crystal whose principal face is the (0001) plane.

**17.** The semiconductor element according to claim 15,
wherein the semiconductor layer is a Si crystal layer;
wherein the principal face of the semiconductor layer is the (100) plane; and
wherein the AlN layer is a cubic crystal whose principal face is the (100) plane.

**18.** The semiconductor element according to claim 14, wherein dangling bonds at the surface of the semiconductor layer are terminated by one of aluminum, nitrogen, hydrogen, sulfur and magnesium.

**19.** The semiconductor element according to any of claims 14 to 18,
wherein the insulating film is a gate insulating film; and
wherein the semiconductor element further comprises a silicon nitride layer interposed between the AlN layer and the semiconductor layer.

**20.** The semiconductor element according to any of claims 14 to 18,
wherein the insulating film is a gate insulating film; and
wherein the semiconductor element further includes a dielectric layer formed on the AlN layer, wherein the dielectric layer is made of at least one of a dielectric material with a higher dielectric constant than AlN and a material with ferroelectric properties.

**21.** The semiconductor element according to any of claims 14 to 18,
wherein the insulating film is a gate insulating film;
wherein the semiconductor element further includes a dielectric layer formed on the AlN film, wherein the dielectric layer is composed of at least one of either a dielectric material with a higher dielectric constant than AlN or a material with ferroelectric properties; and
wherein a conductive film with crystallinity is provided above or below, or above and below the dielectric layer.

**22.** The semiconductor element according to claim 14,
wherein the AlN layer includes at least one of oxygen, hydrogen, and sulfur, and
wherein strain in the AlN layer resulting from lattice mismatching with the semiconductor layer is relieved.

**23.** The semiconductor element according to claim 14, wherein the lattice mismatch between the AlN layer and the semiconductor layer is expanded to increase the dielectric constant of the AlN layer.

Fig. 1(a)

2 dangling bonds

1 Si substrate

Fig. 1(b)

N atoms 4

3

5a

1

Fig. 1(c)

3 Al atoms

4

5b

1

Fig. 1(d)

7 AlN crystal layer

1

Fig. 2(b)

Fig. 2(a)

dangling bonds

10 hydrogen atoms

11 termination chemical species

Fig. 2(c)

Fig. 2(d)

12 end atoms

Fig. 2(e)

Fig. 2(f)

N atoms 4

3 Al atoms

5a

5b

12

12

Fig. 2(g)

7 AlN crystal layer

Fig. 3(a)

Fig. 3(b)

Fig. 3(c)

Fig. 4(a)    ～1

Fig. 4(b)    ～7   ～1

Fig. 4(c)    ～21   ～7   ～1

Fig. 4(d)    ～22   ～21   ～7   ～1

Fig. 4(e)    ～23   ～22   ～21   ～7   ～1

Fig. 5(a) ⌇1

⇩

Fig. 5(b) ⌇25
⌇1

⇩

Fig. 5(c) ⌇26
⌇25
⌇1

## Fig. 6

54 { 54b
54a

53

55

52

51

57    56    57

# Fig. 7

Fig. 8

Fig. 9

high-frequency
electric power

N2 gas

# Fig. 10

66 (N supply)

open

67 (Al supply)

$\Delta t (\fallingdotseq 3 (min))$

close

t1    t2

time ⟶

Fig. 11(a) — 2 dangling bonds, 1 Si substrate

Fig. 11(b) — 3, 4, Al N atoms, 5b, 1

Fig. 11(c) — 80 AlN crystal layer, 1

Fig. 12

Fig. 13

# INTERNATIONAL SEARCH REPORT

| International application No. |
| --- |
| PCT/JP00/04477 |

**A. CLASSIFICATION OF SUBJECT MATTER**
Int.Cl⁷   H01L21/318, 29/78, 29/788, 29/792, 21/8247, 27/10

According to International Patent Classification (IPC) or to both national classification and IPC

**B. FIELDS SEARCHED**

Minimum documentation searched (classification system followed by classification symbols)
Int.Cl⁷   H01L21/318, 21/203, 29/78, C30B23/08

Documentation searched other than minimum documentation to the extent that such documents are included in the fields searched
Jitsuyo Shinan Koho          1926-1996     Toroku Jitsuyo Shinan Koho  1994-2000
Kokai Jitsuyo Shinan Koho  1971-2000     Jitsuyo Shinan Toroku Koho  1996-2000

Electronic data base consulted during the international search (name of data base and, where practicable, search terms used)
F TERM SYSTEM
WPI/L

**C. DOCUMENTS CONSIDERED TO BE RELEVANT**

| Category* | Citation of document, with indication, where appropriate, of the relevant passages | Relevant to claim No. |
| --- | --- | --- |
| X | JP, 11-162852, A (TDK Corporation),<br>18 June, 1999 (18.06.99),<br>Par. Nos. 0060 to 0068   (Family: none) | 1-4 |
| A | US, 5616947, A1 (Matsushita Electric Industrial Co.),<br>01 April, 1997 (01.04.97),<br>Column 6, line 15 to Column 7, line 17<br>& JP, 8-153867, A<br>Par. Nos. 0042 to 0048 | 1-13 |
| X<br>Y<br>A | JP, 64-82671, A (NEC Corporation),<br>28 March, 1989 (28.03.89),<br>Full text   (Family: none) | 14<br>15<br>16-23 |
| X<br>Y<br>A | JP, 10-223901, A (Sony Corporation),<br>21 August, 1998 (21.08.98),<br>Full text<br>& US, 5929467, A1 | 14<br>15<br>16-23 |
| Y | JP, 62-92327, A (Hitachi, Ltd.),<br>27 April, 1987 (27.04.87),<br>page 3, upper left column, line 18 to upper right column, | 15 |

☒ Further documents are listed in the continuation of Box C.       ☐ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>27 September, 2000 (27.09.00) | Date of mailing of the international search report<br>10 October, 2000 (10.10.00) |
| --- | --- |
| Name and mailing address of the ISA/<br>Japanese Patent Office | Authorized officer |
| Facsimile No. | Telephone No. |

Form PCT/ISA/210 (second sheet) (July 1992)

EP 1 209 729 A1

## INTERNATIONAL SEARCH REPORT

International application No.

PCT/JP00/04477

C (Continuation).   DOCUMENTS CONSIDERED TO BE RELEVANT

| Category* | Citation of document, with indication, where appropriate, of the relevant passages | Relevant to claim No. |
|---|---|---|
| | line 3   (Family: none) | |
| A | JP, 9-309795, A (Fine Ceramics Center), 02 December, 1997 (02.12.97), Full text   (Family: none) | 1-13 |
| A | JP, 1-211976, A (NEC Corporation), 25 August, 1989 (25.08.89), Full text   (Family: none) | 11-13 |

Form PCT/ISA/210 (continuation of second sheet) (July 1992)

29

**INTERNATIONAL SEARCH REPORT**

International application No.

PCT/JP00/04477

Pay attention to the following errors.

Claim 10 refers to claim 11.  However, there is no description including the term, nitrogen in claim 11.
Claim 13 refers to claim 13 itself.
There is an expression "the gate insulating film" in claim 14, but there is no term, a gate insulating film, mentioned before and referred to in the claim.

Form PCT/ISA/210 (extra sheet) (July 1992)